(19) Europäisches Patentamt

European Patent Office

Office européen des brevets

(11) **EP 1 300 953 A1**

(12) **DEMANDE DE BREVET EUROPEEN**

(43) Date de publication:
**09.04.2003 Bulletin 2003/15**

(51) Int Cl.7: **H03M 13/19**, G06F 11/10

(21) Numéro de dépôt: 02354151.9

(22) Date de dépôt: **03.10.2002**

(84) Etats contractants désignés:
**AT BE BG CH CY CZ DE DK EE ES FI FR GB GR
IE IT LI LU MC NL PT SE SK TR**
Etats d'extension désignés:
**AL LT LV MK RO SI**

(30) Priorité: **05.10.2001 FR 0112863**

(71) Demandeur: **STMicroelectronics S.A.
92120 Montrouge (FR)**

(72) Inventeur: **Murillo, Laurent
38240 Meylan (FR)**

(74) Mandataire: **de Beaumont, Michel
1bis, rue Champollion
38000 Grenoble (FR)**

(54) **Code de détection et/ou de correction d'erreurs à haute efficacité**

(57) L'invention concerne un procédé pour déterminer r bits de détection d'erreur d'un mot de m bits à coder comprenant l'étape consistant à faire le produit d'un vecteur à m composantes représentatif dudit mot de m bits à coder et d'une matrice de contrôle de parité (M). La matrice de contrôle de parité comporte au moins deux colonnes consécutives complémentaires. L'invention concerne aussi un procédé pour déterminer un syndrome, ainsi qu'un circuit de codage et de décodage.

$$M = \begin{pmatrix} \begin{matrix} A_0 & A_1 & A_2 & A_3 & A_4 & A_5 & A_6 & A_7 \end{matrix} \\ \begin{matrix} 0 & 1 & 0 & 1 & 0 & 1 & 0 & 1 & 0 & 1 & 0 & 1 & 0 & 1 & 0 & 1 \\ 0 & 1 & 0 & 1 & 0 & 1 & 0 & 1 & 1 & 0 & 1 & 0 & 1 & 0 & 1 & 0 \\ 1 & 1 & 0 & 1 & 1 & 0 & 1 & 0 & 0 & 1 & 0 & 1 & 1 & 0 & 1 & 0 \\ 1 & 1 & 1 & 0 & 0 & 1 & 1 & 0 & 0 & 1 & 1 & 0 & 0 & 1 & 1 & 0 \\ 0 & 1 & 1 & 0 & 1 & 0 & 1 & 0 & 1 & 0 & 1 & 0 & 1 & 0 & 0 & 1 \\ 1 & 0 & 0 & 1 & 0 & 1 & 0 & 1 & 0 & 1 & 0 & 1 & 0 & 1 & 1 & 0 \end{matrix} \end{pmatrix} \begin{matrix} \\ \\ \\ \\ \}\,K \\ \}\,L \end{matrix}$$

Fig 4A

Printed by Jouve, 75001 PARIS (FR)

EP 1 300 953 A1

## Description

La présente invention concerne les codes de détection et/ou de correction d'erreurs.

Les codes de correction d'erreur ont un effet technique et résolvent un problème technique important. En effet, ils permettent de restituer la valeur d'un ou plusieurs bits erronés, par exemple à la suite d'un stockage ou d'une transmission. On peut même affirmer que, sans eux, tout stockage ou transmission d'informations numériques serait illusoire.

La présente invention concerne en particulier les codes linéaires de type Hamming.

Le code de Hamming est un code de détection et de correction d'erreurs utilisé dans de nombreux domaines. On va d'abord décrire un premier exemple de code de Hamming et son utilisation en stockage de données dans une mémoire, dans le cas où les données à mémoriser sont sous forme de mots de 16 bits.

Soit X le mot à stocker. X peut être représenté par un vecteur Xe, dont les 16 composantes $X_0$ à $X_{15}$ correspondent aux 16 bits du mot à stocker. Cinq bits de détection d'erreur $C_i$ ($C_0$ à $C_4$) sont obtenus en multipliant une matrice de contrôle de parité H, dite matrice de Hamming, de dimension 5 x 16, par le vecteur Xe, sous forme de vecteur colonne.

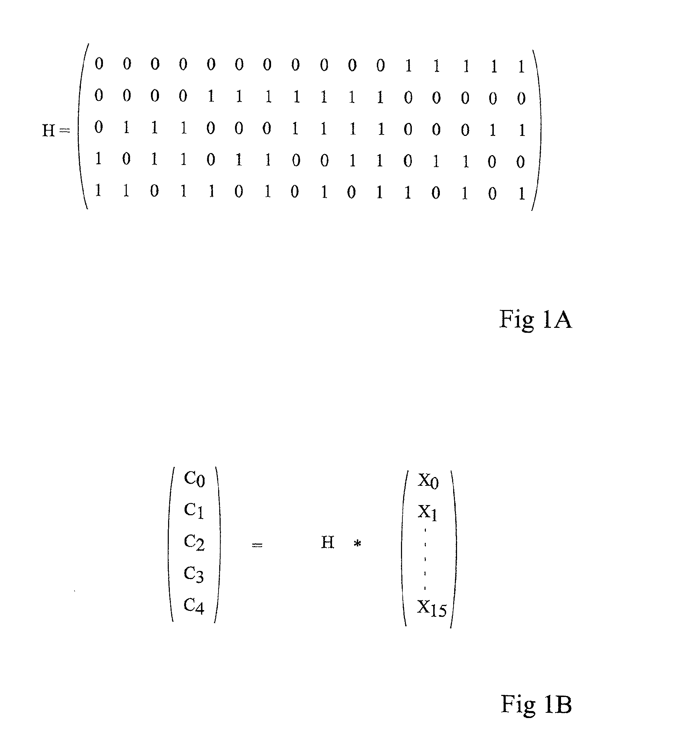

La figure 1A illustre la matrice de Hamming H pour 16 bits et la figure 1B le mode d'obtention des bits de détection. Si l'on appelle $h_{ij}$ les éléments de la matrice H, les bits de détection d'erreur $C_i$ sont donnés par :

$$Ci = \sum_{j=0}^{15} hij . Xj$$

$X_j$ étant la jième composante du vecteur Xe.

En écriture, on inscrit dans la mémoire des mots de 21 bits, formés des 16 bits de données $X_j$ et des 5 bits de détection $C_i$. En lecture, le mot lu comprend 16 bits $X_r$ correspondant aux bits de données et 5 bits $C_r$ correspondant aux bits de détection. $X_r$ et $C_r$ peuvent ne pas être égaux à $X_j$ et $C_i$ si des erreurs ont eu lieu entre les opérations d'écriture et de lecture.

Pour détecter et/ou corriger des erreurs éventuelles sur les bits lus, un syndrome S à cinq composantes S0... S4 est calculé en multipliant une matrice déterminée H' de dimension 5 x 21 par un vecteur colonne à 21 composantes, comprenant les 16 bits $X_r$ et les 5 bits $C_r$.

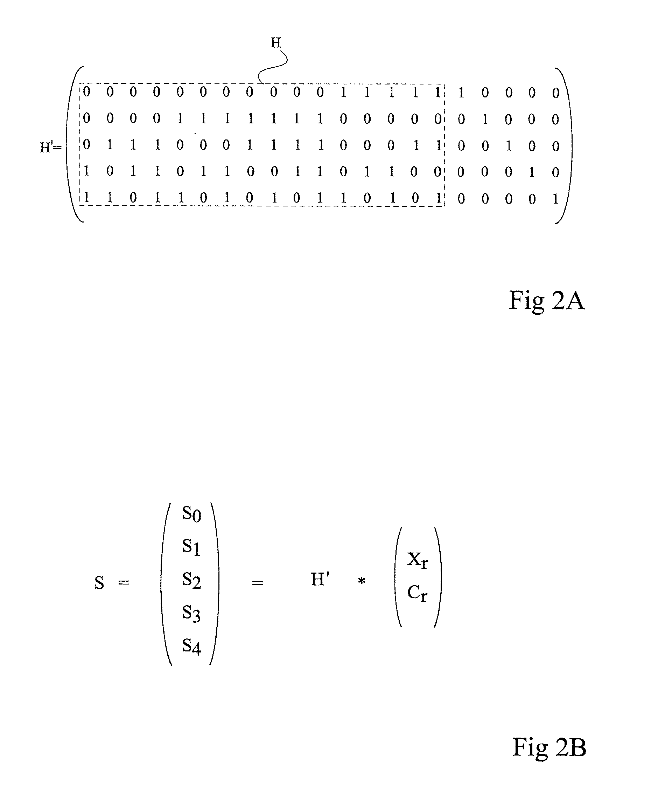

La figure 2A illustre la matrice H'. Les 16 premières colonnes de la matrice H' correspondent aux 16 colonnes de la matrice H. Les 5 colonnes suivantes comprennent chacune un seul "1". La 17ème colonne a son "1" sur la première ligne, la 18ème colonne a son "1" sur la deuxième ligne, et ainsi de suite jusqu'à la 21ème colonne, qui a son "1" sur la cinquième ligne. Les cinq dernières colonnes de la matrice H' servent à déterminer des erreurs éventuelles dans les bits de détection.

La figure 2B illustre le calcul du syndrome S.

Si le syndrome S a toutes ses composantes égales à 0, le stockage a eu lieu sans erreur et tous les bits du mot lu, bits de données ou bits de détection, sont corrects.

Si S est différent de 0, le mot lu comporte une ou plusieurs erreurs. Si un seul bit du mot lu est erroné, le syndrome obtenu permet de corriger l'erreur. En effet, le syndrome correspond dans ce cas à la colonne dont les éléments ont été multipliés par le bit erroné. Ainsi, si le syndrome calculé est égal à :

$$S = \begin{pmatrix} 0 \\ 0 \\ 0 \\ 1 \\ 1 \end{pmatrix},$$

les composantes (00011) du syndrome correspondent aux éléments de la première colonne de la matrice de Hamming et cela signifie que le premier bit, $X_0$, est erroné.

De même, si le syndrome calculé est égal à

$$S'' = \begin{pmatrix} 1 \\ 0 \\ 0 \\ 0 \\ 0 \end{pmatrix},$$

et qu'il n'y a qu'une seule erreur dans le mot lu, cela signifie que c'est le premier bit de détection $C_0$ qui est erroné.

Le code ci-dessus ne pouvant pas détecter deux erreurs, on le transforme généralement en adjoignant au mot à coder un bit de parité totale P.

Le bit de parité totale P est calculé en faisant la somme modulo 2 de tous les bits de données et de tous les bits de détection. Le bit de parité totale est ajouté au mot à coder, et le mot codé, c'est-à-dire l'ensemble constitué par le mot à stocker, les bits de détection et le bit de parité totale, est mémorisé.

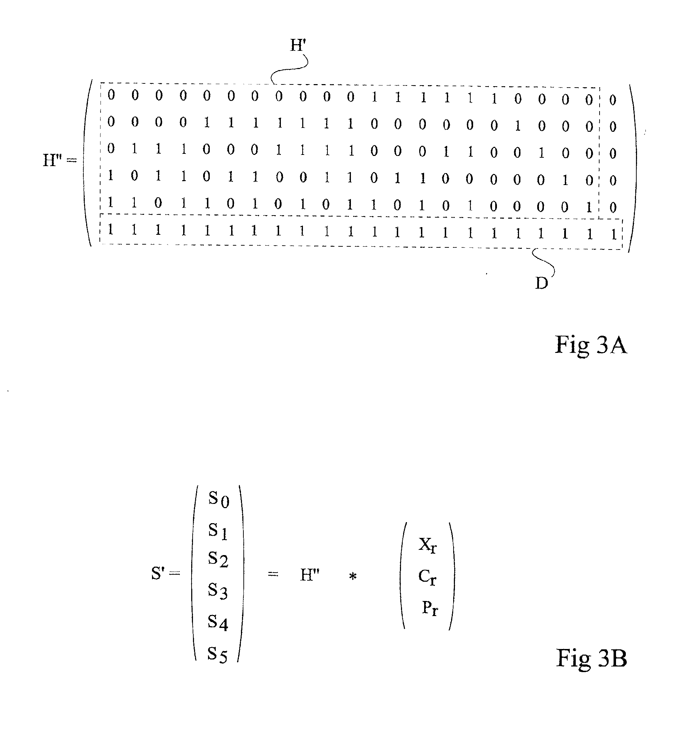

En lecture, le mot lu est multiplié par la matrice de contrôle de parité H" représentée en figure 3A. La matrice H" a une ligne et une colonne de plus que la matrice H'. La matrice H" comporte, en haut et à gauche, c'est-à-dire sur les cinq premières lignes et les 21 premières colonnes, un bloc identique à la matrice H'. La dernière ligne D de la matrice H" ne comporte que des "1", et la dernière colonne de la matrice H" ne comporte que des "0", à l'exception de la dernière ligne.

Le syndrome obtenu S' est illustré en figure 3B. Le syndrome S' comporte six composantes S0 à S5, et est obtenu en multipliant la matrice H" par un vecteur colonne comportant les 22 bits du mot lu, composé des 16 bits de données lus $X_r$, suivis des cinq bits de détection lus $C_r$ et du bit de parité totale lu $P_r$.

Ce deuxième code est du type "SEC-DED" ("Single Error Correction" - "Double Error Detection"), signifiant "Correction d'une erreur - Détection de deux erreurs". Il peut détecter deux erreurs dans tous les cas, deux erreurs étant indiquées par le fait que la dernière composante du syndrome, S5, est nulle alors que le syndrome est différent du vecteur nul.

Les bits de détection et le bit de parité totale sont calculés par un circuit de codage, et les composantes du syndrome sont calculées par un circuit de décodage. Ces circuits comportent un grand nombre d'additionneurs modulo 2 élémentaires. Chaque additionneur élémentaire nécessitant un certain temps pour effectuer une addition, les résultats fournis par les circuits de codage et de décodage présentent un certain délai. Il est souhaitable de réduire ce délai. En outre, les additionneurs de l'art antérieur sont relativement petits et leur réalisation, non optimale, ne leur permet pas d'être rapides.

Un objet de la présente invention est de prévoir un code de détection et/ou de correction d'erreurs permettant l'optimisation des modules élémentaires de calcul des circuits de codage et de décodage.

Un autre objet de la présente invention est de prévoir un procédé et un dispositif pour mettre en oeuvre un tel code.

Un autre objet de la présente invention est de prévoir un code de détection et/ou de correction d'erreurs permettant la correction d'une erreur et la détection de deux erreurs qui est plus simple que le code de Hamming correspondant.

Un autre objet de la présente invention est de prévoir un procédé et un dispositif pour mettre en oeuvre un tel code de détection et/ou de correction d'erreurs.

Pour atteindre ces objets ainsi que d'autres, la présente invention prévoit un procédé pour déterminer r bits de détection d'erreur d'un mot de m bits à coder comprenant l'étape consistant à faire le produit d'un vecteur à m composantes représentatif dudit mot de m bits à coder et d'une matrice de contrôle de parité. La matrice de contrôle de parité comporte au moins deux colonnes consécutives complémentaires.

Selon un mode de réalisation de la présente invention, toutes les colonnes de ladite matrice sont complémentaires, à l'exception des deux premières.

Selon un mode de réalisation de la présente invention, m étant pair, ladite matrice est telle que :

a) à l'exception de la première colonne, de rang 0, la représentation binaire des r-2 premiers éléments de chaque colonne de rang pair 2i correspond au rang i d'un couple dont fait partie la colonne ;

b) les deux derniers éléments de chaque colonne de rang pair 2i sont "10", à l'exception des colonnes de rang 0 et m-2, où ils sont "01" ; et

c) la première colonne de ladite matrice est formée de r-4 éléments égaux à "0", suivis des éléments "1101" et la deuxième colonne de ladite matrice, de rang 1, comprend des "1" sur les r-1 premières lignes et un "0" sur la dernière ligne.

Selon un mode de réalisation de la présente invention, des lignes et/ou des colonnes sont permutées.

Selon un mode de réalisation de la présente invention, le nombre r des bits de détection est égal à n+2, n étant le nombre de bits nécessaire pour représenter, en binaire, le nombre m de bits à coder.

La présente invention concerne aussi un procédé de détermination d'un syndrome représentatif d'erreurs éventuelles survenues au cours d'un traitement, à un mot de m+r bits, les m+r bits correspondant, avant traitement à m bits d'un mot à coder et r bits de détection d'erreurs obtenus par un procédé défini ci-dessus appliqué au mot de m bits à coder, le syndrome étant obtenu au cours d'une étape consistant à multiplier une matrice particulière par un vecteur à m+r composantes représentatives du mot de m+r bits. La matrice particulière comporte :

a) pour les colonnes de rang 0 à m-1, un premier bloc correspondant à la matrice de contrôle de parité utilisée au codage ;

b) pour les r-1 premières lignes des colonnes de rang m à m+r-2, un second bloc, carré de dimension r-1, en forme de matrice diagonale ne comportant que des "1" sur sa diagonale principale,

c) sous le second bloc, pour la dernière ligne des colonnes de rang m à m+r-2, des éléments inverses de ceux de la dernière ligne du second bloc ; et

d) une dernière colonne ne comportant que des "0" sur les r-1 premières lignes et un "1" sur la dernière ligne.

La présente invention concerne aussi un circuit de codage comportant des additionneurs élémentaires et permettant le calcul de bits de détection à l'aide d'une matrice de contrôle de parité telle que définie ci-dessus, la répartition des additionneurs élémentaires correspondant à la répartition des "1" dans ladite matrice.

Selon un mode de réalisation de la présente invention, le circuit de codage comporte m entrées, chaque entrée étant couplée à une colonne du circuit et recevant un bit du mot à coder. Chaque additionneur élémentaire s'étend sur un espace correspondant sensiblement à la distance séparant trois colonnes consécutives du circuit.

La présente invention concerne aussi un circuit de décodage comportant des additionneurs élémentaires et permettant la détermination d'un syndrome à l'aide d'une matrice particulière telle que définie ci-dessus, la répartition des additionneurs élémentaires correspondant à la répartition des "1" dans ladite matrice particulière.

Selon un mode de réalisation de la présente invention, le circuit de décodage comporte m+r entrées, chaque entrée étant couplée à une colonne du circuit et recevant un bit du mot à décoder. Chaque additionneur s'étend sur un espace correspondant sensiblement à la distance séparant trois colonnes consécutives du circuit, à l'exception des additionneurs des colonnes m à m+r qui possèdent deux additionneurs voisins immédiats.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

les figures 1A et 1B, précédemment décrites, représentent respectivement une matrice de Hamming H et le mode d'obtention de bits de détection pour coder un mot de 16 bits ;

les figures 2A et 2B, précédemment décrites, représentent respectivement une matrice de Hamming H' pour calculer un syndrome et le mode de calcul du syndrome pour un mot de 16 bits ;

les figures 3A et 3B, précédemment décrites, représentent respectivement une matrice de Hamming H" utilisée dans un code permettant de détecter deux erreurs pour des mots de 16 bits et le mode de calcul du syndrome correspondant ;

la figure 4A représente une matrice de contrôle de parité M selon la présente invention pour coder un mot de 16 bits ;

la figure 4B représente une matrice M' utilisée pour calculer un syndrome selon la présente invention ;

la figure 5A illustre le principe d'un circuit utilisé au codage pour coder un mot à l'aide de la matrice M ;

la figure 5B représente un élément du circuit de la figure 5A ;

la figure 5C représente une ligne du circuit utilisé au codage ;

la figure 5D représente une autre ligne du circuit utilisé au codage ;

la figure 6 représente un circuit utilisé pour calculer un syndrome ; et

la figure 7 représente une matrice M'32 selon la présente invention utilisée au décodage pour des mots de 32 bits.

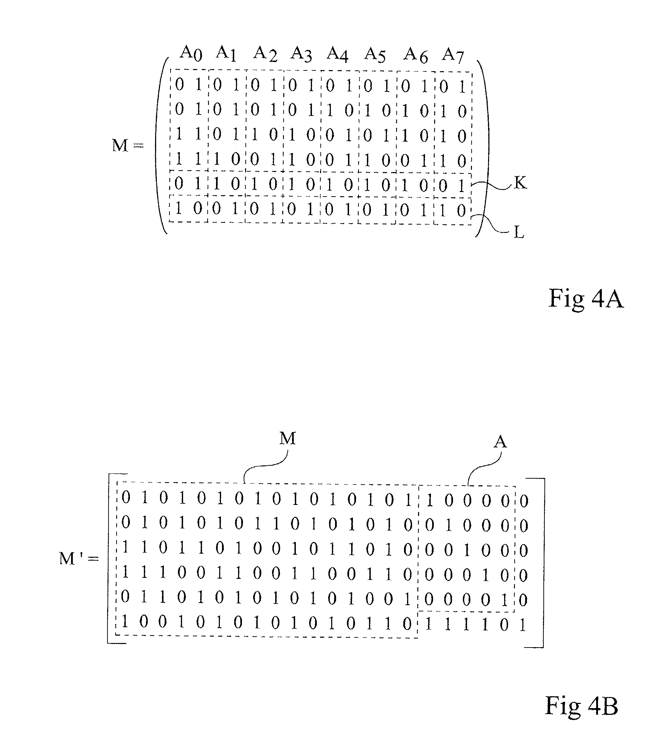

La figure 4A représente un exemple de matrice de contrôle de parité M pour calculer des bits de détection pour des mots de 16 bits, dans un code de correction/détection d'erreur selon la présente invention. Le nombre de bits de détection est égal à 6 et la matrice M est de dimension 6 x 16. Chaque colonne de la matrice M est différente d'une autre et les colonnes sont deux à deux linéairement indépendantes. En outre, chaque colonne de la matrice M est complémentaire d'une colonne immédiatement adjacente, à l'exception des deux premières colonnes.

La matrice M peut être décomposée en huit couples $A_i$ de deux colonnes adjacentes, i allant de 0 à 7. Le couple $A_0$ correspond aux colonnes de rang 0 et de rang 1, le couple $A_1$ aux colonnes de rang 2 et de rang 3, etc. Dans l'exemple de matrice M représenté en figure 4A, donné à titre non limitatif, les deux colonnes d'un couple $A_i$ sont complémentaires, à l'exception du couple $A_0$. En figure 4A, les couples $A_i$ sont formés de la façon suivante.

Pour les couples $A_1$ à $A_7$, les quatre premiers éléments de la première colonne d'un couple correspondent à la représentation binaire du rang i du couple $A_i$. Ainsi, la première colonne du couple $A_3$ a ses quatre premiers éléments égaux à "0011", qui est la représentation binaire du nombre 3.

Les quatre premiers éléments de la première colonne du couple A0 (colonne de rang 0) sont choisis égaux à "0011". Ce choix n'est pas critique. Les quatre premiers éléments de la colonne de rang 0 peuvent en effet avoir n'importe quelle valeur, pourvu que la colonne de rang 0 une fois complète soit différente de toute autre colonne de la matrice M ou des colonnes relatives aux bits de détection de la matrice utilisée au décodage, M', que l'on décrira par la suite. Le choix retenu ("0011") présente l'avantage d'utiliser un faible nombre de "1", d'où une simplification des circuits de codage et de décodage, le nombre de "1" correspondant, comme on le verra par la suite, au nombre d'additionneurs dans le circuit.

Les deux derniers éléments de chaque première colonne d'un couple $A_i$ (colonnes de rang pair) sont égaux "10", sauf pour les premier et dernier couples $A_i$ (colonnes de rang 0 et 14), où ils sont égaux à "01".

Sauf pour le premier couple, $A_0$, chaque deuxième colonne d'un couple $A_i$ est complémentaire de la première colonne du couple. En d'autres termes, sauf pour la colonne de rang 1, les éléments de chaque colonne de rang impair sont les compléments à deux (ou inverses) des éléments de la colonne de rang pair immédiatement précédente, et vice versa. Par exemple, les éléments de la première colonne du couple A4 sont égaux à "010010", et les éléments de la deuxième colonne de ce couple sont "101101". En figure 4A, le couple A0 a pour première colonne "001101" et pour deuxième colonne "111110".

On notera que l'avant-dernière ligne de la matrice M, référencée K, ayant pour éléments "0110101010101001", est complémentaire de la dernière ligne de la matrice M, référencée L, ayant pour éléments "1001010101010110". Cela procure des avantages, comme on le verra par la suite.

Lorsque l'on multiplie la matrice M par un vecteur colonne de seize composantes correspondant aux bits du mot à coder, on obtient six bits de détection $C_0$-$C_5$, qui sont ajoutés au mot à coder pour former un mot codé de 22 bits.

La figure 4B illustre la matrice M' utilisée au décodage. Au décodage, un vecteur de 22 composantes, correspondant aux 22 bits du mot à décoder (16 bits de données et 6 bits de détection après traitement quelconque, par exemple stockage dans une mémoire ou transmission), est multiplié par la matrice M' pour former un syndrome à six composantes $S_0$-$S_5$. La matrice M' est une matrice de dimension 6 x 22. Dans la matrice M', les seize première colonnes forment un bloc identique à la matrice M. Les cinq premières lignes des cinq colonnes suivantes (rang 16 à 20) forment un bloc A de dimension 5 x 5 constitué par une matrice diagonale ne comprenant que des "1" sur sa diagonale principale et des "0" partout ailleurs. Sous le bloc A, les éléments de la dernière ligne des colonnes de rang 16 à 20 sont choisis égaux à "11110", de façon à correspondre aux inverses des éléments de la dernière ligne du bloc A ("00001"). La dernière colonne de la matrice M', celle qui permet de corriger une erreur sur le sixième bit de détection, comprend des "0" sur les cinq premières lignes et un "1" sur la dernière ligne.

On notera que, dans la matrice M', les colonnes correspondant aux bits de données sont deux à deux complémentaires, à l'exception des deux premières. En outre, les deux dernières lignes sont complémentaires aussi. Si l'on fait la somme modulo 2 des deux dernières composantes du syndrome, $S_4$ et $S_5$, on obtient la somme modulo 2 de tous les bits de données et de détection du mot à décoder, c'est-à-dire un bit de parité totale $P_r$. Le bit de parité totale $P_r$ est ici obtenu de façon simple et est calculé sensiblement en deux fois moins de temps que dans le cas du code de Hamming correspondant. En outre au codage, contrairement au code de Hamming correspondant, un bit de parité totale P n'est pas calculé. Le bit de parité totale $P_r$ est utilisé de la manière suivante.

Si le syndrome est égal au vecteur nul, il n'y a pas d'erreurs, ni dans les bits de données, ni dans les bits de détection.

Si le syndrome est différent du vecteur nul et le bit de parité total $P_r$ est égal à 1, cela signifie qu'il y a eu une seule erreur et elle peut être corrigée. En effet, les composantes du syndrome, dans ce cas, correspondent aux éléments de la colonne de la matrice M' correspondant au bit erroné.

Si le syndrome est différent du vecteur nul et le bit de parité total $P_r$ est égal à 0, on se trouve dans le cas de deux erreurs, qui sont détectées.

La figure 5A représente schématiquement le principe d'un circuit utilisé au codage permettant de calculer les bits de détection à partir des bits de données. Le circuit de codage 1 comporte 16 entrées E0 à E15, qui reçoivent les 16 bits de données $X_0$ à $X_{15}$ du mot à coder. Le circuit 1 comporte également 6 sorties $C_0$ à $C_5$ fournissant les six bits de détection. Chaque entrée Ei est reliée à une colonne de rang i du circuit. Chaque sortie $C_j$ est reliée à une ligne de rang j. A l'intersection de la colonne i et de la ligne j peut se trouver un additionneur modulo 2 $G_{i,j}$ indiqué sommairement ici par un cercle marqué d'une croix. Les additionneurs modulo 2 peuvent être quelconques, et constitués par exemple par des portes OU-Exclusif.

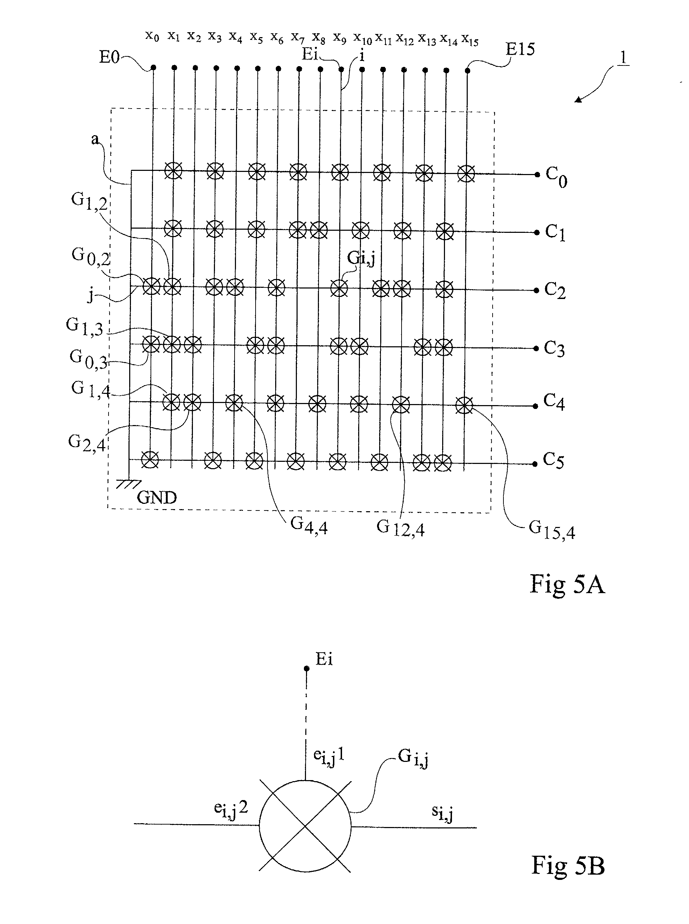

Comme cela est représenté en figure 5B, l'additionneur $G_{i,j}$ comporte deux entrées $e_{i,j}1$ et $e_{i,j}2$, souvent notées respectivement e1 et e2 dans la suite, par souci de simplification. L'entrée $e_{i,j}1$ est reliée à l'entrée Ei et l'entrée $e_{i,j}2$ reçoit le signal présent sur la ligne j à gauche de l'additionneur $G_{i,j}$. L'additionneur $G_{i,j}$ comporte aussi une sortie $s_{i,j}$ située sur la ligne j à droite de l'additionneur $G_{i,j}$, notée souvent plus simplement s par la suite.

Lorsqu'il n'y a pas d'additionneur à l'intersection de la colonne i et de la ligne j, la colonne i et la ligne j se croisent sans influence l'une sur l'autre. Cela signifie que le bit fourni à l'entrée concernée n'est pas utilisé pour le calcul du bit de détection $C_j$.

Une colonne supplémentaire, a, située à gauche de la colonne de rang 0 relie l'entrée e2 de chaque premier additionneur d'une ligne à la masse (GND).

Le fonctionnement du circuit 1 va être expliqué pour le calcul du bit de détection $C_4$, correspondant à la ligne de rang 4. En partant de la gauche, le premier additionneur rencontré est l'additionneur $G_{1,4}$. L'entrée e2 de l'additionneur $G_{1,4}$ est reliée à la masse, par l'intermédiaire de la colonne a, et l'entrée e1 de l'additionneur $G_{1,4}$ reçoit le bit de données $X_1$ par l'intermédiaire de l'entrée E1 du circuit. En sortie de l'additionneur $G_{1,4}$, on a s = 0 $\oplus$ $X_1$, c'est-à-dire $X_1$. Le signal fourni par l'additionneur $G_{1,4}$ attaque l'entrée e2 de l'additionneur $G_{2,4}$, qui effectue le calcul $X_1$ $\oplus$ $X_2$. Le calcul se poursuit ainsi jusqu'à l'additionneur $G_{15,4}$, qui réalise l'addition modulo 2 du résultat fourni par l'additionneur $G_{12,4}$ et du bit de données $X_{15}$. Ainsi, on a :

$$C_4 = X_1 \oplus X_2 \oplus X_4 \oplus X_6 \oplus X_8 \oplus X_{10} \oplus X_{12} \oplus X_{15},$$

ce qui correspond bien à la multiplication de la cinquième ligne de la matrice M par un vecteur ayant pour composantes les bits du mot à coder. De façon générale, le circuit 1 reprend la structure de la matrice M, les lignes et les colonnes du circuit correspondant aux lignes et aux colonnes de la matrice M, un additionneur modulo 2 étant situé là où la matrice M comporte un "1". Dans l'art antérieur, chaque additionneur occupe un espace correspondant à l'intervalle entre deux colonnes du circuit.

On va maintenant décrire l'avantage procuré par le fait que des colonnes adjacentes de la matrice M sont complémentaires.

En effet, dans la présente invention, un additionneur modulo 2 du circuit 1 n'est jamais contigu des deux côtés à un autre additionneur, sauf le cas échéant pour les deux premières colonnes. Il en résulte qu'un tel additionneur peut occuper latéralement la place de deux additionneurs et être, pour une même surface du circuit, deux fois plus gros que dans l'art antérieur. L'additionneur peut alors être réalisé de façon optimale, et être beaucoup plus rapide.

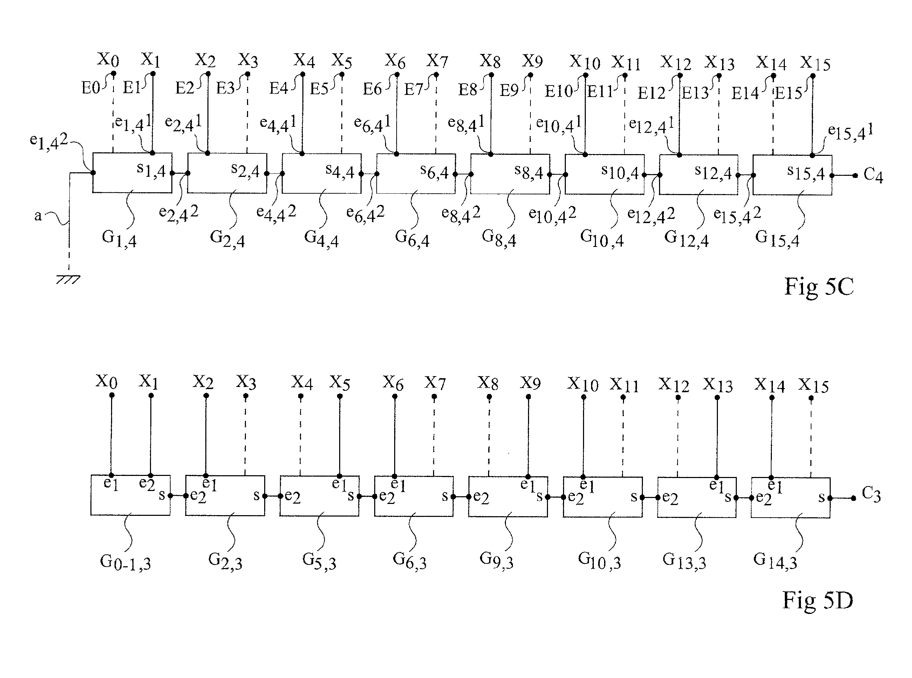

La figure 5C illustre la ligne de rang 4 du circuit 1, fournissant le bit de détection $C_4$. Chaque additionneur $G_{i,j}$ est représenté sous la forme d'un bloc rectangulaire. Le premier additionneur rencontré est l'additionneur $G_{1,4}$. Son entrée e2 ($e_{1,4}2$) est reliée à la masse par l'intermédiaire de la colonne a. Son entrée e1 ($e_{1,4}1$) reçoit le bit $X_1$ par l'intermédiaire de l'entrée E1. En figure 5C, les colonnes du circuit 1 qui ne sont pas reliées à l'entrée d'un additionneur de la ligne de rang 4 sont représentées en pointillés. La sortie $s_{i,j}$ de chacun des additionneurs alimente l'entrée e2 de l'additionneur suivant ou, pour le dernier additionneur, la sortie du circuit. La ligne de rang 4 du circuit de codage comprend huit additionneurs ($G_{1,4}$, $G_{2,4}$, $G_{4,4}$, $G_{6,4}$, $G_{8,4}$, $G_{10,4}$, $G_{12,4}$ et $G_{15,4}$), les bits de données utilisés pour le calcul du bit de détection $C_4$ étant $X_1$, $X_2$, $X_4$, $X_6$, $X_8$, $X_{10}$, $X_{12}$ et $X_{15}$. Tous les additionneurs de la ligne de rang 4 sont de surface double par rapport à ce qui est prévu dans l'art antérieur.

Bien qu'en figure 5C l'entrée e1 d'un additionneur $G_{i,j}$ soit située tantôt à gauche, tantôt à droite de l'additionneur, tous les additionneurs du circuit peuvent présenter la même structure physique. Dans ce cas, l'entrée e1 est disposée à un même emplacement déterminé de l'additionneur, un jeu de vias ou de liaisons permettant au bit souhaité d'alimenter l'entrée concernée.

Dans la matrice M de la figure 4A, les deux premières colonnes ne sont pas complémentaires. Cependant, indépendamment de ce fait, les additionneurs correspondant aux deux premières colonnes du circuit 1 peuvent être de même taille que les additionneurs du reste du circuit. D'abord, un problème se pose seulement lorsque deux "1" consécutifs se trouvent sur les deux premières colonnes d'une même ligne de la matrice. Cela ne se produit que pour les lignes de rang 2 et 3. Ensuite, il est possible, même dans ces cas, d'utiliser des additionneurs de taille deux fois supérieure à l'art antérieur.

Examinons par exemple le cas de la ligne de rang 3. Le premier additionneur de la ligne, $G_{0,3}$ (figure 5A), est suivi de l'additionneur $G_{1,3}$. L'additionneur $G_{0,3}$ réalise l'addition modulo 2 du bit X0 et de 0 (potentiel de la masse). L'additionneur $G_{0,3}$ fournit en sortie le bit X0. Son rôle n'est donc que de transmettre le bit de données qu'il reçoit à l'additionneur suivant. Dans la présente invention, les deux additionneurs $G_{0,3}$ et $G_{1,3}$ sont remplacés par un seul additionneur, non relié à la masse et recevant sur ses deux entrées les bits $X_0$ et $X_1$.

Ainsi, en figure 5D, qui représente la ligne de rang 3 du circuit 1, un seul additionneur, noté $G_{0-1,3}$, remplace les additionneurs $G_{0,3}$ et $G_{1,3}$ de la figure 5A. L'additionneur $G_{0-1,3}$ a deux entrées e1 et e2 recevant respectivement les bits de données $X_0$ et $X_1$. L'additionneur $G_{0-1,3}$ fournit en sortie la somme modulo 2 des bits $X_1$ et $X_2$. L'additionneur $G_{0-1,3}$ occupe la superficie des deux additionneurs $G_{0,3}$ et $G_{0,1}$. L'additionneur $G_{0-1,3}$ est de même taille que les additionneurs qui le suivent, à savoir les additionneurs $G_{2,3}$, $G_{5,3}$, $G_{6,3}$, $G_{9,3}$, $G_{10,3}$, $G_{13,3}$ et $G_{14,3}$, connectés selon les principes énoncés ci-dessus. La ligne de rang 3 du circuit fournit le bit de détection $C_3$, somme modulo 2 des bits de données $X_0$, $X_1$, $X_2$, $X_5$, $X_6$, $X_9$, $X_{10}$, $X_{13}$ et $X_{14}$.

Les deux premiers additionneurs de la ligne de rang 2 de la figure 5A, $G_{0,2}$ et $G_{1,2}$, sont de même remplacés par un seul additionneur non représenté, $G_{0-1,2}$, non relié à la masse et recevant sur ses deux entrées les bits de données $X_0$ et $X_1$.

Le circuit 1, non représenté en détail ici, est ainsi formé de 48 additionneurs (8 additionneurs par ligne), disposant tous d'une même superficie de silicium, double de celle prévue par l'art antérieur. Chacun des additionneurs peut être de réalisation plus soignée et, du fait des performances optimales individuelles de chacun des additionneurs, le calcul des bits de détection peut être beaucoup plus rapide.

En outre, du fait que la matrice de codage M a deux de ses lignes complémentaires, un bit de parité totale P n'est pas calculé au codage. Les 6 bits de détection $C_0$ à $C_5$ peuvent être calculés en parallèle et ajoutés au mot à coder sans perte de temps supplémentaire.

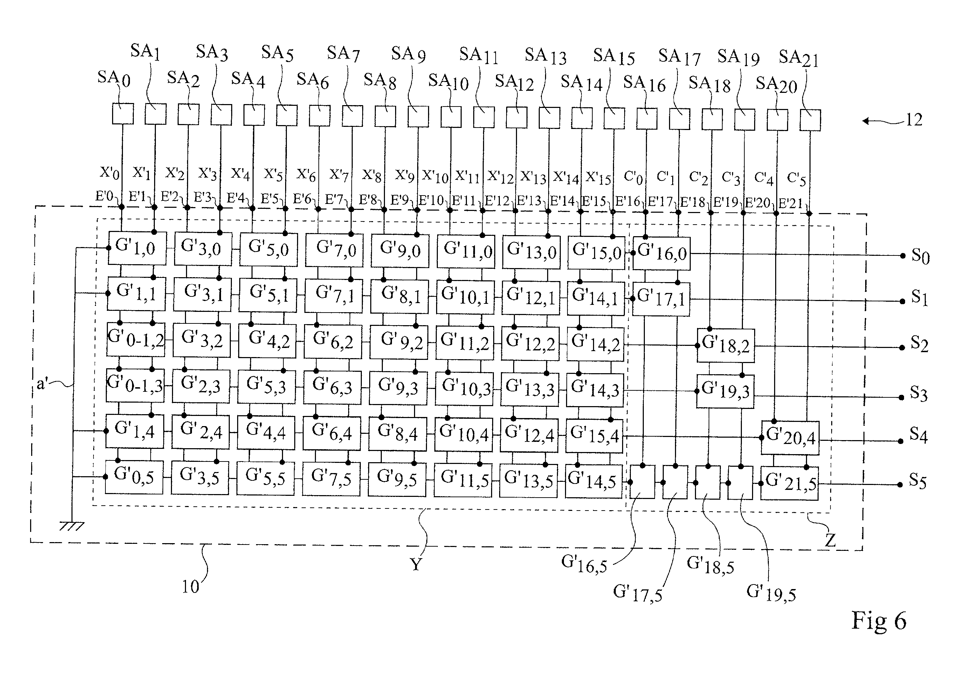

La figure 6 représente schématiquement un circuit 10 utilisé au décodage. Le circuit 10 comporte 22 entrées E'0 à E'21 recevant les 22 bits du mot à décoder (16 bits de données $X'_0$ à $X'_{15}$ et 6 bits de détection $C'_0$ à $C'_5$). Le circuit 10 comporte six sorties $S_0$ à $S_5$ fournissant chacune une composante du syndrome. Le circuit 10 représenté ici est réalisé directement en sortie d'une mémoire dont seule est représentée une ligne 12 de 22 amplificateurs de lecture $SA_0$ à $SA_{21}$ ("sense amplifiers" en anglais). Les amplificateurs de lecture $SA_i$ sont situés chacun à l'extrémité d'une ligne de bits non représentée (le cas échéant, deux lignes de bits pour une mémoire DRAM) et fournissent chacun un bit du mot à décoder. Les amplificateurs de lecture $SA_0$ à $SA_{15}$ fournissent les bits de données $X'_0$ à $X'_{15}$ et les amplificateurs de lecture $SA_{16}$ à $SA_{21}$ fournissent les bits de détection $C'_0$ à $C'_5$. Le circuit de décodage 10 est réalisé sur la même puce de silicium que la mémoire dans laquelle est stocké le mot codé et peut faire partie intégrante de celle-ci. Chacune des entrées E'i du circuit 10 est espacée d'une autre entrée par l'intervalle séparant deux amplificateurs de lecture $SA_i$.

Le circuit 10 comprend d'abord, relié aux entrées E'0 à E'15, un bloc Y formé d'un pavage régulier de six lignes de huit additionneurs $G'_{i,j}$ chacune. La structure du bloc Y reprend la structure du circuit de codage 1, les 16 premières colonnes de la matrice M' correspondant à la matrice M. Les additionneurs $G'_{i,j}$ du bloc Y sont connectés de la même manière que cela a été décrit précédemment en relation avec les figures 5A à 5D. On peut d'ailleurs avoir une image du circuit 1 en se reportant au bloc Y, en remplaçant les éléments marqués d'un "prime" par des éléments sans "prime".

Les additionneurs $G'_{1,0}$, $G'_{1,1}$, $G'_{1,4}$ et $G'_{0,5}$, correspondant respectivement aux premiers additionneurs des lignes de rang 0, 1, 4 et 5, possèdent une entrée reliée à une ligne de masse a' et une entrée reliée selon les cas au bit de données $X_0$ ou $X_1$. Les premiers additionneurs des lignes de rang 2 et 3, $G'_{0-1,2}$ et $G'_{0-1,3}$, reçoivent en entrée les deux bits de données $X_0$ et $X_1$. Les autres additionneurs du bloc Y, correspondant aux colonnes de rang 2 à 15, comportent une entrée reliée à la sortie de l'additionneur qui le précède immédiatement et une autre entrée reliée à une des deux entrées $E'_i$ susceptibles d'alimenter l'additionneur.

Outre le bloc Y, le circuit 10 comprend un bloc Z de dix additionneurs reliés aux entrées E'16 à E'21, chargés de réaliser les opérations mathématiques sur les bits de données. Sur la ligne de rang 0 du bloc Z, il n'y a qu'un seul additionneur, $G'_{16,0}$, qui reçoit la sortie de l'additionneur $G'_{15,0}$ sur une entrée, et le bit de détection $C'_0$ sur une autre entrée. La sortie de l'additionneur $G'_{16,0}$ alimente la sortie $S_0$ du circuit. L'additionneur $G'_{16,0}$ peut occuper, si cela est souhaité, un espace s'étendant sur six colonnes du circuit 10 (amplificateurs de lecture $SA_{16}$ à $SA_{21}$). Cependant, pour des raisons pratiques, l'additionneur $G'_{16,0}$ est de même type que les additionneurs $G'_{i,j}$ du bloc Y et occupe une surface double de ce qui est prévu dans l'art antérieur.

La ligne de rang 1 du bloc Z comprend également un seul additionneur $G'_{17,1}$, de même surface que l'additionneur $G'_{15,0}$, recevant sur ses deux entrées la sortie de l'additionneur $G'_{14,1}$ et le bit de détection $C'_1$. La sortie de l'additionneur $G'_{17,1}$ alimente la sortie $S_1$ du circuit 10.

La ligne 2 du bloc Z comprend un additionneur $G'_{18,2}$, de même taille que l'additionneur $G'_{15,0}$ ou $G'_{17,1}$, recevant sur une entrée la sortie de l'additionneur $G'_{14,2}$ et sur son autre entrée le bit de détection $C'_2$. L'additionneur $G'_{18,2}$ alimente la sortie $S_2$ du circuit.

Sur la ligne suivante du bloc Z, se trouve l'additionneur $G'_{19,3}$, de même taille que l'additionneur $G'_{18,2}$, recevant en entrée la sortie de l'additionneur $G'_{14,3}$ et le bit de détection $C'_3$. L'additionneur $G'_{19,3}$ alimente la sortie $S_3$ du circuit 10.

La ligne de rang 4 du bloc Z comprend un additionneur $G'_{20,4}$, recevant la sortie de l'additionneur $G'_{15,4}$ et le bit de détection $C'_4$. L'additionneur $G'_{20,4}$ alimente la sortie $S_4$ du circuit 10.

La dernière ligne du bloc Z, de rang 5, comporte cinq additionneurs qui ne peuvent utiliser chacun une surface double de circuit. En effet, sur cette ligne, l'additionneur $G'_{14,5}$ du bloc Y alimente un additionneur $G'_{16,5}$, suivi, dans cet ordre, des additionneurs $G'_{17,5}$, $G'_{18,5}$, $G'_{19,5}$ et $G'_{21,5}$. L'additionneur $G'_{21,5}$ alimente la sortie $S_5$ du circuit 10. Les additionneurs $G'_{16,5}$, $G'_{17,5}$, $G'_{18,5}$ et $G'_{19,5}$, qui reçoivent respectivement les bits de détection $C'_0$, $C'_1$, $C'_2$ et $C'_3$, ne peuvent être plus larges que l'intervalle séparant deux colonnes du circuit. Leur largeur ne peut donc être supérieure à celle d'un amplificateur de lecture. L'additionneur $G'_{21,5}$, par contre, recevant la sortie de l'amplificateur $G'_{19,5}$ et le bit de détection $C'_5$, peut être aussi large que deux amplificateurs de lecture et de taille semblable à celle des additionneurs du bloc Y.

L'examen de la figure 6 nous indique que presque tous les additionneurs du circuit de décodage occupent une surface double de ce qui est prévu dans l'art antérieur. Les additionneurs de surface double peuvent être beaucoup plus rapides que les additionneurs de surface moitié et de ce fait, le circuit de décodage est beaucoup plus rapide que dans l'art antérieur.

On notera en outre que, tant en ce qui concerne le circuit de codage que le circuit de décodage, le nombre d'additionneurs par ligne est réduit par rapport à l'art antérieur. Il en résulte un gain supplémentaire de temps. A titre de comparaison, on se rapportera à la dernière ligne de la matrice H" de l'art antérieur (figure 3A), constituée de 22 "1" consécutifs. Ainsi, la dernière ligne du circuit de décodage correspondant comprend 22 additionneurs de petite taille en série. Dans la présente invention, avec la matrice M', la dernière ligne du circuit de décodage ne comporte que 13 additionneurs, dont 9 ont une surface double par rapport à l'art antérieur. Le gain de temps intervient donc à deux niveaux. En effet, dans la présente invention, non seulement presque tous les additionneurs sont plus volumineux donc plus rapides, mais leur nombre par ligne est plus faible. Le temps global de calcul correspondant à la somme des temps de traitement dans chacun des additionneurs, le circuit de l'invention est beaucoup plus rapide et performant que le circuit de l'art antérieur. En outre, la réalisation plus soignée des additionneurs de surface plus grande permet à ceux-ci d'être plus fiables.

Bien entendu, le code de la présente invention ne se limite pas à des codes destinés à des mots de 16 bits. En effet, il est possible, moyennant la complémentarité d'au moins deux colonnes consécutives, ce qui permet de réduire le temps de traitement des additionneurs concernés par ces colonnes, de définir des codes permettant de coder des mots ayant un nombre quelconque de bits.

Par exemple, il est possible de généraliser la matrice M de la figure 4A pour coder un nombre m pair quelconque de bits. Le nombre de bits de détection r doit être au moins supérieur de 2 au nombre nécessaire pour représenter, en binaire, le nombre de bit du mot à coder. De préférence, r sera égal à sa valeur minimale, pour ne pas alourdir le code. Ainsi, lorsque m est égal à 16, il faut quatre bits pour représenter seize possibilités en binaire et r est choisi égal à 6, comme cela a été vu précédemment. Pour m = 32, le nombre de bits de détection est choisi égal à 7, 32 étant égal à $2^5$. Pour m = 128, il faut 9 bits de détection, et ainsi de suite.

Pour généraliser la matrice M, on détermine d'abord le nombre r de bits de détection nécessaires. Ensuite, on construit la matrice Mm servant au codage de sorte que les r-2 premiers éléments de chaque colonne de rang pair indiquent, sauf pour la première colonne, le rang du couple dont fait partie la colonne (un couple $A_i$, de rang i, est constitué de la colonne de rang pair 2i et de la colonne de rang impair 2i+1 ; le rang de la première colonne est 0, et celui de la dernière colonne m-1). Les deux derniers éléments des colonnes de rang pair sont égaux à "10" sauf pour la colonne de rang 0 et la colonne de rang m-2, où ils valent "01".

La première colonne de la matrice Mm peut être formée de r-4 éléments égaux à "0", suivis des éléments "1101". La deuxième colonne de la matrice Mm, de rang 1, peut être formée de r-4 éléments égaux à "1", suivis des éléments "1110". Les colonnes de rang impair, à l'exception de la colonne de rang 1, sont complémentaires de la colonne de rang pair immédiatement précédente.

On notera que la dernière ligne de la matrice Mm est complémentaire de son avant-dernière ligne.

On notera aussi que les r-2 premiers éléments de la première colonne de la matrice Mm peuvent être identiques aux r-2 éléments de n'importe quelle colonne de la matrice Mm, aux conditions suivantes : la première colonne doit être différente de toutes les autres colonnes de la matrice Mm ; les quatre premiers éléments de la première colonne ne doivent pas être que des "0" et comporter plus d'un "1", afin que la colonne soit différente des colonnes de la matrice utilisée au décodage qui correspondent aux bits de détection.

Pour former la matrice M'm servant au décodage, on prend d'abord la matrice de contrôle de parité Mm, et on la complète à droite par une sous-matrice carrée R de dimension r x r. La sous-matrice R comprend des "1" sur sa diagonale principale, et des "0" partout ailleurs sauf sur sa dernière ligne, dont les éléments sont les inverses de ceux de l'avant-dernière ligne de la sous-matrice R. La dernière ligne de la sous-matrice R comporte ainsi des "1" partout sauf à l'avant dernière colonne.

Le code utilisant les matrices Mm et M'm a une distance minimale de code égale à quatre. Il permet de corriger une erreur et de détecter deux erreurs. Au décodage, le syndrome obtenu a r composantes. Un bit de parité totale est obtenu en ajoutant modulo 2 les deux dernières composantes du syndrome.

Si le syndrome est le vecteur nul, il n'y a pas d'erreur. Si le syndrome est différent du vecteur nul et le bit de parité totale est égal à "1", il y a une seule erreur. Cette erreur est aisément corrigée car le syndrome correspond à la colonne de la matrice dont les éléments ont été multipliés par le bit erroné. Si le syndrome est différent du vecteur nul et le bit de parité total est égal à "0", l'on est en présence de deux erreurs.

Tous les additionneurs du circuit de codage et pratiquement tous les additionneurs du circuit de décodage, calculant respectivement les bits de détection et les composantes du syndrome à l'aide des matrices Mm et M'm, peuvent s'étendre sur deux intervalles séparant deux colonnes du circuit et avoir une surface double de celle prévue par l'art antérieur.

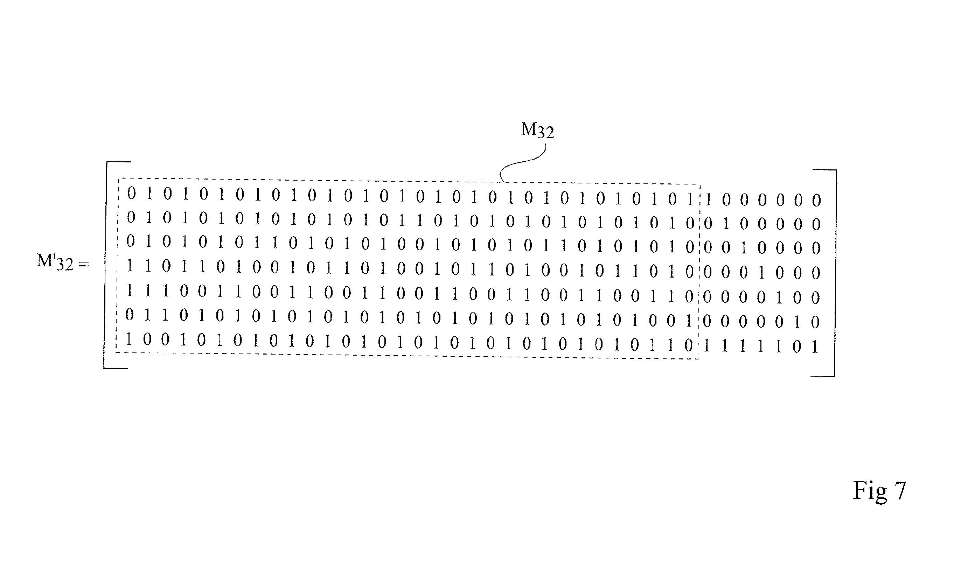

La figure 7, à titre d'exemple, illustre une matrice M'32 utilisée pour décoder des mots de 32 bits. La matrice M'32 est de dimension 7 x 39. Ses 32 premières colonnes correspondent à la matrice M32 utilisée au codage. Les matrices M32 et M'32 sont réalisées sur le modèle de ce qui a été décrit précédemment. Les circuits de codage et de décodage correspondants, non représentés, se déduisent facilement des matrices M32 et M'32 à l'aide des principes définis en relation avec les figures 5A-5D et 6.

Bien entendu, la présente invention est susceptible de diverses variantes et modifications qui apparaîtront à l'homme de l'art. En particulier, toute permutation de ligne d'une matrice de contrôle de parité selon la présente invention fait partie du domaine de l'invention et ne change en rien le code de l'invention. Toute permutation de colonnes d'une matrice de la présente invention fait aussi partie du domaine de la présente invention, pour autant que deux colonnes consécutives au moins restent complémentaires.

Le nombre N de bits du mot à coder peut être pair ou impair. Si le nombre N est impair, on peut par exemple d'abord former une matrice Mm telle que décrite ci-dessus avec m pair et égal à N+1. Ensuite, la matrice $M_N$ à utiliser au codage peut dériver aisément de la matrice Mm par suppression d'une colonne quelconque, par exemple la première colonne.

L'invention a principalement été décrite dans le cadre du stockage de mots en mémoire. Bien entendu, la présente invention s'applique également à tout codage et décodage de mots auxquels on veut affecter un code de détection et/ou de correction d'erreur. Par exemple, la présente invention s'applique à la transmission.

**Revendications**

1.  Procédé pour déterminer r bits de détection d'erreur ($C_0$, ... $C_{r-1}$) d'un mot de m bits à coder comprenant l'étape consistant à faire le produit d'un vecteur à m composantes représentatif dudit mot de m bits à coder et d'une matrice de contrôle de parité (M, Mm, M32), **caractérisé en ce que** la matrice de contrôle de parité comporte au moins deux colonnes consécutives complémentaires.

2.  Procédé selon la revendication 1, dans lequel toutes les colonnes de ladite matrice sont complémentaires, à l'exception des deux premières.

3. Procédé selon la revendication 2, dans lequel, m étant pair, ladite matrice est telle que :

     a) à l'exception de la première colonne, de rang 0, la représentation binaire des r-2 premiers éléments de chaque colonne de rang pair 2i correspond au rang i d'un couple ($A_i$) dont fait partie la colonne ;
     b) les deux derniers éléments de chaque colonne de rang pair 2i sont "10", à l'exception des colonnes de rang 0 et m-2, où ils sont "01" ; et
     c) la première colonne de ladite matrice est formée de r-4 éléments égaux à "0", suivis des éléments "1101" et la deuxième colonne de ladite matrice, de rang 1, comprend des "1" sur les r-1 premières lignes et un "0" sur la dernière ligne.

4. Procédé selon l'une quelconque des revendications 1 à 3, dans lequel des lignes et/ou des colonnes sont permutées.

5. Procédé selon l'une quelconque des revendications 1 à 4, dans lequel le nombre r des bits de détection est égal à n+2, n étant le nombre de bits nécessaire pour représenter, en binaire, le nombre m de bits à coder.

6. Procédé de détermination d'un syndrome représentatif d'erreurs éventuelles survenues au cours d'un traitement, à un mot de m+r bits, les m+r bits correspondant, avant traitement à m bits d'un mot à coder et r bits de détection d'erreurs obtenus par un procédé selon l'une quelconque des revendications 1 à 5 appliqué au mot de m bits à coder, le syndrome étant obtenu au cours d'une étape consistant à multiplier une matrice particulière (M', M'm, M'32) par un vecteur à m+r composantes représentatives du mot de m+r bits, **caractérisé en ce que** la matrice particulière comporte :

     a) pour les colonnes de rang 0 à m-1, un premier bloc correspondant à la matrice de contrôle de parité utilisée au codage ;
     b) pour les r-1 premières lignes des colonnes de rang m à m+r-2, un second bloc, carré de dimension r-1, en forme de matrice diagonale ne comportant que des "1" sur sa diagonale principale,
     c) sous le second bloc, pour la dernière ligne des colonnes de rang m à m+r-2, des éléments inverses de ceux de la dernière ligne du second bloc ; et
     d) une dernière colonne ne comportant que des "0" sur les r-1 premières lignes et un "1" sur la dernière ligne.

7. Circuit de codage (1) comportant des additionneurs élémentaires et permettant le calcul de bits de détection à l'aide d'une matrice de contrôle de parité (M, Mm, M32) telle que définie dans l'une quelconque des revendications 1 à 5, **caractérisé en ce que** la répartition des additionneurs élémentaires correspond à la répartition des "1" dans ladite matrice.

8. Circuit selon la revendication 7 comportant m entrées (Ei), chaque entrée étant couplée à une colonne du circuit et recevant un bit du mot à coder, dans lequel chaque additionneur élémentaire s'étend sur un espace correspondant sensiblement à la distance séparant trois colonnes consécutives du circuit.

9. Circuit de décodage (10) comportant des additionneurs élémentaires et permettant la détermination d'un syndrome à l'aide d'une matrice particulière (M', M'm, M'32) telle que définie dans la revendication 6, **caractérisé en ce que** la répartition des additionneurs élémentaires correspond à la répartition des "1" dans ladite matrice particulière.

10. Circuit selon la revendication 9 comportant m+r entrées (E'i), chaque entrée étant couplée à une colonne du circuit et recevant un bit du mot à décoder, dans lequel chaque additionneur s'étend sur un espace correspondant sensiblement à la distance séparant trois colonnes consécutives du circuit, à l'exception des additionneurs des colonnes m à m+r qui possèdent deux additionneurs voisins immédiats.

$$H = \begin{pmatrix} 0 & 0 & 0 & 0 & 0 & 0 & 0 & 0 & 0 & 0 & 0 & 1 & 1 & 1 & 1 & 1 \\ 0 & 0 & 0 & 0 & 1 & 1 & 1 & 1 & 1 & 1 & 1 & 0 & 0 & 0 & 0 & 0 \\ 0 & 1 & 1 & 1 & 0 & 0 & 0 & 1 & 1 & 1 & 1 & 0 & 0 & 0 & 1 & 1 \\ 1 & 0 & 1 & 1 & 0 & 1 & 1 & 0 & 0 & 1 & 1 & 0 & 1 & 1 & 0 & 0 \\ 1 & 1 & 0 & 1 & 1 & 0 & 1 & 0 & 1 & 0 & 1 & 1 & 0 & 1 & 0 & 1 \end{pmatrix}$$

Fig 1A

$$\begin{pmatrix} c_0 \\ c_1 \\ c_2 \\ c_3 \\ c_4 \end{pmatrix} = H * \begin{pmatrix} x_0 \\ x_1 \\ . \\ . \\ . \\ x_{15} \end{pmatrix}$$

Fig 1B

$$H' = \begin{pmatrix} 0 & 0 & 0 & 0 & 0 & 0 & 0 & 0 & 0 & 0 & 0 & 1 & 1 & 1 & 1 & 1 & 1 & 0 & 0 & 0 & 0 \\ 0 & 0 & 0 & 0 & 1 & 1 & 1 & 1 & 1 & 1 & 1 & 0 & 0 & 0 & 0 & 0 & 0 & 1 & 0 & 0 & 0 \\ 0 & 1 & 1 & 1 & 0 & 0 & 0 & 1 & 1 & 1 & 1 & 0 & 0 & 0 & 1 & 1 & 0 & 0 & 1 & 0 & 0 \\ 1 & 0 & 1 & 1 & 0 & 1 & 1 & 0 & 0 & 1 & 1 & 0 & 1 & 1 & 0 & 0 & 0 & 0 & 0 & 1 & 0 \\ 1 & 1 & 0 & 1 & 1 & 0 & 1 & 0 & 1 & 0 & 1 & 1 & 0 & 1 & 0 & 1 & 0 & 0 & 0 & 0 & 1 \end{pmatrix}$$

Fig 2A

$$S = \begin{pmatrix} S_0 \\ S_1 \\ S_2 \\ S_3 \\ S_4 \end{pmatrix} = H' * \begin{pmatrix} X_r \\ C_r \end{pmatrix}$$

Fig 2B

H'

$$H'' = \begin{pmatrix} 0 & 0 & 0 & 0 & 0 & 0 & 0 & 0 & 0 & 0 & 0 & 1 & 1 & 1 & 1 & 1 & 1 & 0 & 0 & 0 & 0 & 0 \\ 0 & 0 & 0 & 0 & 1 & 1 & 1 & 1 & 1 & 1 & 1 & 0 & 0 & 0 & 0 & 0 & 0 & 1 & 0 & 0 & 0 & 0 \\ 0 & 1 & 1 & 1 & 0 & 0 & 0 & 1 & 1 & 1 & 1 & 0 & 0 & 0 & 1 & 1 & 0 & 0 & 1 & 0 & 0 & 0 \\ 1 & 0 & 1 & 1 & 0 & 1 & 1 & 0 & 0 & 1 & 1 & 0 & 1 & 1 & 0 & 0 & 0 & 0 & 0 & 1 & 0 & 0 \\ 1 & 1 & 0 & 1 & 1 & 0 & 1 & 0 & 1 & 0 & 1 & 1 & 0 & 1 & 0 & 1 & 0 & 0 & 0 & 0 & 1 & 0 \\ 1 & 1 & 1 & 1 & 1 & 1 & 1 & 1 & 1 & 1 & 1 & 1 & 1 & 1 & 1 & 1 & 1 & 1 & 1 & 1 & 1 & 1 \end{pmatrix}$$

D

Fig 3A

$$S' = \begin{pmatrix} s_0 \\ s_1 \\ s_2 \\ s_3 \\ s_4 \\ s_5 \end{pmatrix} = H'' * \begin{pmatrix} X_r \\ C_r \\ P_r \end{pmatrix}$$

Fig 3B

$$M = \begin{pmatrix} A_0 & A_1 & A_2 & A_3 & A_4 & A_5 & A_6 & A_7 \\ 0\ 1 & 0\ 1 & 0\ 1 & 0\ 1 & 0\ 1 & 0\ 1 & 0\ 1 & 0\ 1 \\ 0\ 1 & 0\ 1 & 0\ 1 & 0\ 1 & 1\ 0 & 1\ 0 & 1\ 0 & 1\ 0 \\ 1\ 1 & 0\ 1 & 1\ 0 & 1\ 0 & 0\ 1 & 0\ 1 & 1\ 0 & 1\ 0 \\ 1\ 1 & 1\ 0 & 0\ 1 & 1\ 0 & 0\ 1 & 1\ 0 & 0\ 1 & 1\ 0 \\ 0\ 1 & 1\ 0 & 1\ 0 & 1\ 0 & 1\ 0 & 1\ 0 & 1\ 0 & 0\ 1 \\ 1\ 0 & 0\ 1 & 0\ 1 & 0\ 1 & 0\ 1 & 0\ 1 & 0\ 1 & 1\ 0 \end{pmatrix} \begin{matrix} \\ \\ \\ \\ \\ \}K \\ \}L \end{matrix}$$

Fig 4A

$$M' = \begin{bmatrix} \overbrace{0\ 1\ 0\ 1\ 0\ 1\ 0\ 1\ 0\ 1\ 0\ 1\ 0\ 1\ 0\ 1}^{M} & \overbrace{1\ 0\ 0\ 0\ 0}^{A} & 0 \\ 0\ 1\ 0\ 1\ 0\ 1\ 0\ 1\ 1\ 0\ 1\ 0\ 1\ 0\ 1\ 0 & 0\ 1\ 0\ 0\ 0 & 0 \\ 1\ 1\ 0\ 1\ 1\ 0\ 1\ 0\ 0\ 1\ 0\ 1\ 1\ 0\ 1\ 0 & 0\ 0\ 1\ 0\ 0 & 0 \\ 1\ 1\ 1\ 0\ 0\ 1\ 1\ 0\ 0\ 1\ 1\ 0\ 0\ 1\ 1\ 0 & 0\ 0\ 0\ 1\ 0 & 0 \\ 0\ 1\ 1\ 0\ 1\ 0\ 1\ 0\ 1\ 0\ 1\ 0\ 1\ 0\ 0\ 1 & 0\ 0\ 0\ 0\ 1 & 0 \\ 1\ 0\ 0\ 1\ 0\ 1\ 0\ 1\ 0\ 1\ 0\ 1\ 0\ 1\ 1\ 0 & 1\ 1\ 1\ 1\ 0 & 1 \end{bmatrix}$$

Fig 4B

Fig 5A

Fig 5B

EP 1 300 953 A1

$X_0$ $X_1$ $X_2$ $X_3$ $X_4$ $X_5$ $X_6$ $X_7$ $X_8$ $X_9$ $X_{10}$ $X_{11}$ $X_{12}$ $X_{13}$ $X_{14}$ $X_{15}$

E0 E1 E2 E3 E4 E5 E6 E7 E8 E9 E10 E11 E12 E13 E14 E15

$e_{1,4}^1$ $e_{2,4}^1$ $e_{4,4}^1$ $e_{6,4}^1$ $e_{8,4}^1$ $e_{10,4}^1$ $e_{12,4}^1$ $e_{15,4}^1$

$e_{1,4}^2$

$s_{1,4}$ $s_{2,4}$ $s_{4,4}$ $s_{6,4}$ $s_{8,4}$ $s_{10,4}$ $s_{12,4}$ $s_{15,4}$ $C_4$

a

$e_{2,4}^2$ $e_{4,4}^2$ $e_{6,4}^2$ $e_{8,4}^2$ $e_{10,4}^2$ $e_{12,4}^2$ $e_{15,4}^2$

$G_{1,4}$ $G_{2,4}$ $G_{4,4}$ $G_{6,4}$ $G_{8,4}$ $G_{10,4}$ $G_{12,4}$ $G_{15,4}$

Fig 5C

$X_0$ $X_1$ $X_2$ $X_3$ $X_4$ $X_5$ $X_6$ $X_7$ $X_8$ $X_9$ $X_{10}$ $X_{11}$ $X_{12}$ $X_{13}$ $X_{14}$ $X_{15}$

e1 e2 s e2 e1 s e2 e1 s e2 e1 s e2 e1 s e2 e1 s e2 e1 s e2 e1 s $C_3$

$G_{0-1,3}$ $G_{2,3}$ $G_{5,3}$ $G_{6,3}$ $G_{9,3}$ $G_{10,3}$ $G_{13,3}$ $G_{14,3}$

Fig 5D

EP 1 300 953 A1

$SA_0$ $SA_1$ $SA_2$ $SA_3$ $SA_4$ $SA_5$ $SA_6$ $SA_7$ $SA_8$ $SA_9$ $SA_{10}$ $SA_{11}$ $SA_{12}$ $SA_{13}$ $SA_{14}$ $SA_{15}$ $SA_{16}$ $SA_{17}$ $SA_{18}$ $SA_{19}$ $SA_{20}$ $SA_{21}$

$\leftarrow$ 12

$X'_0$ $X'_1$ $X'_2$ $X'_3$ $X'_4$ $X'_5$ $X'_6$ $X'_7$ $X'_8$ $X'_9$ $X'_{10}$ $X'_{11}$ $X'_{12}$ $X'_{13}$ $X'_{14}$ $X'_{15}$ $C'_0$ $C'_1$ $C'_2$ $C'_3$ $C'_4$ $C'_5$

$E'0$ $E'1$ $E'2$ $E'3$ $E'4$ $E'5$ $E'6$ $E'7$ $E'8$ $E'9$ $E'10$ $E'11$ $E'12$ $E'13$ $E'14$ $E'15$ $E'16$ $E'17$ $E'18$ $E'19$ $E'20$ $E'21$

| $G'1,0$ | $G'3,0$ | $G'5,0$ | $G'7,0$ | $G'9,0$ | $G'11,0$ | $G'13,0$ | $G'15,0$ | $G'16,0$ | $S_0$ |

| $G'1,1$ | $G'3,1$ | $G'5,1$ | $G'7,1$ | $G'8,1$ | $G'10,1$ | $G'12,1$ | $G'14,1$ | $G'17,1$ | $S_1$ |

| $G'0\text{-}1,2$ | $G'3,2$ | $G'4,2$ | $G'6,2$ | $G'9,2$ | $G'11,2$ | $G'12,2$ | $G'14,2$ | $G'18,2$ | $S_2$ |

| $G'0\text{-}1,3$ | $G'2,3$ | $G'5,3$ | $G'6,3$ | $G'9,3$ | $G'10,3$ | $G'13,3$ | $G'14,3$ | $G'19,3$ | $S_3$ |

| $G'1,4$ | $G'2,4$ | $G'4,4$ | $G'6,4$ | $G'8,4$ | $G'10,4$ | $G'12,4$ | $G'15,4$ | $G'20,4$ | $S_4$ |

| $G'0,5$ | $G'3,5$ | $G'5,5$ | $G'7,5$ | $G'9,5$ | $G'11,5$ | $G'13,5$ | $G'14,5$ | $G'21,5$ | $S_5$ |

a'

10

Y

Z

$G'16,5$

$G'17,5$

$G'18,5$

$G'19,5$

Fig 6

M$_{32}$

$$M'_{32} = \begin{bmatrix}
0\ 1\ 0\ 1\ 0\ 1\ 0\ 1\ 0\ 1\ 0\ 1\ 0\ 1\ 0\ 1\ 0\ 1\ 0\ 1\ 0\ 1\ 0\ 1\ 0\ 1\ 0\ 1\ 0\ 1\ 0\ 1 & 1\ 0\ 0\ 0\ 0\ 0\ 0 \\
0\ 1\ 0\ 1\ 0\ 1\ 0\ 1\ 0\ 1\ 0\ 1\ 0\ 1\ 1\ 0\ 1\ 0\ 1\ 0\ 1\ 0\ 1\ 0\ 1\ 0\ 1\ 0\ 1\ 0 & 0\ 1\ 0\ 0\ 0\ 0\ 0 \\
0\ 1\ 0\ 1\ 0\ 1\ 1\ 0\ 1\ 0\ 1\ 0\ 1\ 0\ 0\ 1\ 0\ 1\ 0\ 1\ 0\ 1\ 1\ 0\ 1\ 0\ 1\ 0\ 1\ 0 & 0\ 0\ 1\ 0\ 0\ 0\ 0 \\
1\ 1\ 0\ 1\ 1\ 0\ 1\ 0\ 0\ 1\ 0\ 1\ 1\ 0\ 1\ 0\ 0\ 1\ 0\ 1\ 1\ 0\ 1\ 0\ 0\ 1\ 0\ 1\ 1\ 0 & 0\ 0\ 0\ 1\ 0\ 0\ 0 \\
1\ 1\ 1\ 0\ 0\ 1\ 1\ 0\ 0\ 1\ 1\ 0\ 0\ 1\ 1\ 0\ 0\ 1\ 1\ 0\ 0\ 1\ 1\ 0\ 0\ 1\ 1\ 0\ 0\ 1\ 1\ 0 & 0\ 0\ 0\ 0\ 1\ 0\ 0 \\
0\ 1\ 1\ 0\ 1\ 0\ 1\ 0\ 1\ 0\ 1\ 0\ 1\ 0\ 1\ 0\ 1\ 0\ 1\ 0\ 1\ 0\ 1\ 0\ 1\ 0\ 1\ 0\ 0\ 1 & 0\ 0\ 0\ 0\ 0\ 1\ 0 \\
1\ 0\ 0\ 1\ 0\ 1\ 0\ 1\ 0\ 1\ 0\ 1\ 0\ 1\ 0\ 1\ 0\ 1\ 0\ 1\ 0\ 1\ 0\ 1\ 0\ 1\ 0\ 1\ 1\ 0 & 1\ 1\ 1\ 1\ 1\ 0\ 1
\end{bmatrix}$$

Fig 7

EP 1 300 953 A1

EP 1 300 953 A1

Office européen
des brevets

**RAPPORT DE RECHERCHE EUROPEENNE**

Numéro de la demande

EP 02 35 4151

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | MACWILLIAMS F.J. AND SLOANE N.J.A.: "The theory of error-correcting codes" 1977 , NORTH HOLLAND PUBLISHING COMPANY , AMSTERDAM XP002226718 | 1,5 | H03M13/19 G06F11/10 |
| Y | * page 23 - page 29 * | 2,4 | |
| Y | US 5 751 744 A (BABB BRENDAN J) 12 mai 1998 (1998-05-12) * colonne 3, ligne 9 - ligne 31 * | 2,4 | |
| X | GLICK E W ET AL: "Single error correction, double error detection code utilizing minimum circuitry" IBM TECHNICAL DISCLOSURE BULLETIN, IBM CORP. NEW YORK, US, vol. 15, no. 1, juin 1972 (1972-06), pages 130-134, XP002186242 ISSN: 0018-8689 * le document en entier * | 7,9 | |
| A | US 4 888 774 A (KIRIU YOSHIO ET AL) 19 décembre 1989 (1989-12-19) * le document en entier * | 1-10 | **DOMAINES TECHNIQUES RECHERCHES (Int.Cl.7)** H03M G06F |

Le présent rapport a été établi pour toutes les revendications

| Lieu de la recherche | Date d'achèvement de la recherche | Examinateur |
|---|---|---|
| LA HAYE | 10 janvier 2003 | Ogor, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

18

**ANNEXE AU RAPPORT DE RECHERCHE EUROPEENNE
RELATIF A LA DEMANDE DE BREVET EUROPEEN NO.**

EP 02 35 4151

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-01-2003

| Document brevet cité au rapport de recherche | | Date de publication | Membre(s) de la famille de brevet(s) | | Date de publication |
|---|---|---|---|---|---|
| US 5751744 | A | 12-05-1998 | AUCUN | | |
| US 4888774 | A | 19-12-1989 | JP | 2022560 C | 26-02-1996 |
| | | | JP | 7060394 B | 28-06-1995 |
| | | | JP | 63155237 A | 28-06-1988 |

EPO FORM P0460

Pour tout renseignement concernant cette annexe : voir Journal Officiel de l'Office européen des brevets, No.12/82